Europäisches Patentamt

European Patent Office

Office européen des brevets

(19)

(11) **EP 0 694 786 A1**

## (12) DEMANDE DE BREVET EUROPEEN

(43) Date de publication:
**31.01.1996 Bulletin 1996/05**

(51) Int Cl.6: **G01R 27/02**

(21) Numéro de dépôt: **95401770.3**

(22) Date de dépôt: **26.07.1995**

(84) Etats contractants désignés:
**BE CH DE ES GB GR IT LI NL PT SE**

(30) Priorité: **28.07.1994 FR 9409358**

(71) Demandeur:
**AEROSPATIALE Société Nationale Industrielle
F-75781 Paris Cédex 16 (FR)**

(72) Inventeurs:
- **Bagneux, Jean-Marc
  F-31300 Toulouse (FR)**
- **Le Demeet, Xavier
  F-92600 Asnieres (FR)**

(74) Mandataire: **Dubois-Chabert, Guy et al
F-75008 Paris (FR)**

(54) **Sonde de mesure de résistance surfacique**

(57)    Sonde de mesure de résistance surfacique d'un objet (20), caractérisée en ce qu'elle comporte deux ensembles (12, 14) d'électrodes en regard l'un de l'autre, chaque ensemble comportant :

- une première série d'électrodes (22, 24) reliées en parallèle,

- une deuxième série d'électrodes (32, 34) reliées en parallèle,

les deux séries d'électrodes étant disposées de manière alternative.

FIG. 2

**Description**

Domaine technique et art antérieur

La présente invention se rapporte aux domaines de la mesure de résistance surfacique de matériaux. Elle peut, en particulier, être mise en oeuvre lors de la mesure de résistance surfacique d'éléments plastiques métallisés. Ce type d'éléments se rencontre souvent dans le domaine de l'industrie aérospatiale, et il est important de pouvoir disposer d'appareils et de méthodes permettant de les caractériser, du point de vue électrique, de manière fiable.

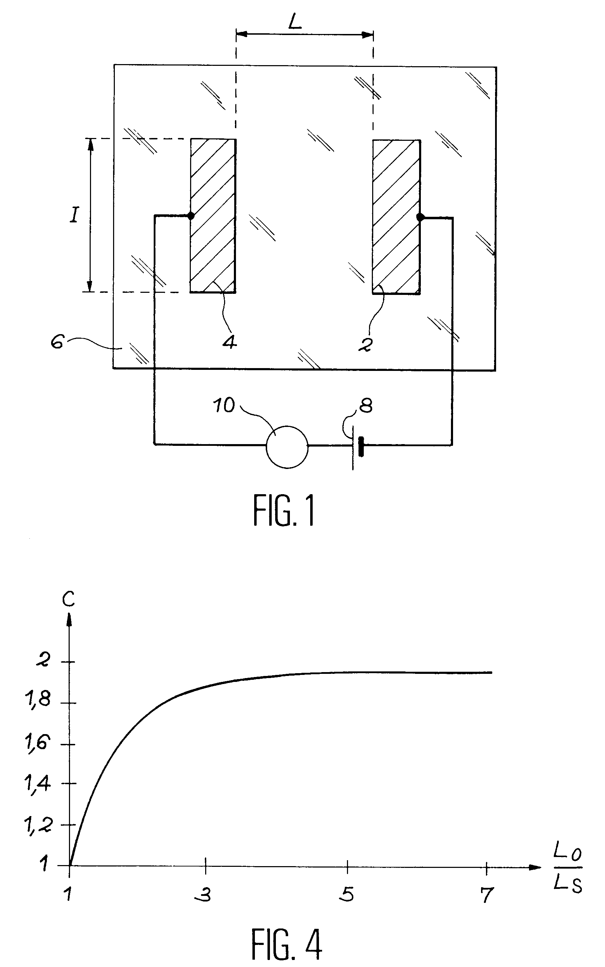

Selon les techniques connues, les mesures de résistivité sont menées le plus fréquemment à l'aide de sondes de contact. Ainsi qu'illustré sur la figure 1, ce type de sonde est constitué de deux électrodes, désignées sur la figure 1 par les références 2 et 4, qui sont placées directement en contact avec le matériau 6 dont on cherche à mesurer la résistivité. En fait, on mesure la résistance du volume du matériau compris entre les deux électrodes 2 et 4. La mesure étant effectuée en courant continu, si le courant I occupe avec une densité uniforme la totalité de la section du conducteur, la résistance mesurée s'écrit s'écrit :

$$R = \rho\,\frac{L}{S} = \rho\frac{L}{1.e}$$

où $\rho$ désigne la résistivité du matériau (en ohm-cm), L désigne la distance entre les deux électrodes de la sonde (en cm), e désigne l'épaisseur du matériau mesuré (en cm), 1 désigne la largeur de l'électrode (en cm), si l'échantillon mesuré est plus large que les électrodes.

Avec une sonde carrée et pour de grands échantillons, on a :

$$R = \frac{\rho}{e}$$

. Cette expression ne dépend pas des dimensions du carré mais uniquement de l'épaisseur du matériau. Si la sonde n'est pas carrée, on peut tout de même se ramener à une résistance par carré en multipliant la résistance mesurée par un coefficient correcteur.

Bien que couramment utilisée, cette technique présente néanmoins certains problèmes. Ainsi, le résultat mesuré est influencé par la résistance du contact entre les électrodes et la surface du matériau à mesurer. En outre, il se peut que des inhomogénéités à la surface du matériau à mesurer, faussent la mesure. Enfin, on suppose, en appliquant cette méthode, qu'il n'y a pas de fuite de ligne de courant à l'extérieur de la sonde. Or, cette hypothèse s'avère inexacte, et la géométrie de la sonde utilisé ne permet pas de minimiser les pertes des lignes de courant à l'extérieur de la sonde.

Exposé de l'invention

La présente invention a pour objet une sonde et un procédé de mesure de la résistance surfacique d'un matériau, qui permettent de résoudre les problèmes évoqués ci-dessus.

Plus précisément, elle a pour objet une sonde de mesure de la résistance surfacique d'un objet, cette sonde comprenant deux ensembles d'électrodes en regard l'un de l'autre, chaque ensemble comportant :

- une première série d'électrodes reliées en parallèle,

- une deuxième série d'électrodes reliées en parallèle, les deux séries d'électrodes étant disposées de manière alternative.

Ainsi constituée, cette sonde permet de faire des mesures en minimisant les pertes des lignes de courant entre les deux séries d'électrodes. Elle permet donc d'obtenir une mesure beaucoup plus fiable. En outre, le résultat est peu influencé par la valeur de la résistance de contact.

Selon un mode particulier de réalisation de l'invention, la sonde comprend en outre :

- des moyens d'alimentation en courant reliés à l'une des séries d'électrodes reliées en parallèle de chaque ensemble d'électrodes, et

- des moyens de mesure de la tension entre les deux autres séries d'électrodes.

Un tel dispositif permet de réaliser une mesure suivant le principe du raccordement en "quatre fils". Ce type de raccordement permet d'éliminer :

- l'influence de la résistance des fils de connexion puisque l'on ne mesure pas la chute de tension dans les fils et que les électrodes de mesure de la tension sont parcourues par un courant négligeable,

- l'influence des chutes de tension au niveau des résistances de contact, puisque l'on ne mesure pas la chute de tension dans les électrodes d'injection et de prélèvement du courant et que les électrodes de mesure de la tension sont parcourues par un courant négligeable.

Selon un autre mode particulier de réalisation de l'invention, chaque ensemble d'électrode est disposée rectilignement, les deux ensembles définissant ainsi deux alignements parallèles d'électrodes.

On peut alors choisir la longueur d'un ensemble d'électrode de manière à ce qu'elle soit sensiblement égale à la longueur de l'autre série d'électrodes ; elle peut être égale à la distance séparant les deux ensembles d'électrodes.

Selon un autre aspect de l'invention, chaque électrode est en forme de pointe à l'extrémité qui est destinée à être en contact avec le matériau à mesurer.

Ceci permet d'améliorer le contact entre les électrodes de mesure et le matériau.

Selon un mode particulier de réalisation de l'invention, les pointes sont montées sur des ressorts.

Un tel montage permet d'absorber les éventuels défauts de planéité du matériau à mesurer, et de percer toute couche d'oxydation qui tendrait à se former en surface du matériau.

L'invention a également pour objet un procédé de mesure de la résistance surfacique d'un matériau, ce procédé comprenant les étapes suivantes :

- l'application sur la surface de l'objet à mesurer, d'une sonde telle que décrite ci-dessus,

- l'injection d'un courant I dans l'objet, par une des deux séries d'un des deux ensembles d'électrodes et le prélèvement de ce courant par une série d'électrodes de l'autre ensemble d'électrodes,

- la mesure d'une tension V entre les deux autres séries d'électrodes,

- le calcul de la résistance surfacique

$$R = \frac{V}{I}$$

,

- la correction du résultat par un facteur correcteur C préétabli dépendant de la largeur de l'échantillon par rapport à la largeur de la sonde.

Ce procédé présente d'une part les avantages exposés ci-dessus en liaison avec la présentation de la sonde. D'autre part, le facteur de correction est simple à calculer.

Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :

- la figure 1, déjà décrite, représente un dispositif de mesure de la résistance surfacique d'un matériau, selon l'art antérieur,

- la figure 2 représente, vue de dessus, une sonde de mesure de la résistance surfacique d'un matériau, selon la présente invention,

- la figure 3 représente, vue de côté, une sonde de mesure de la résistance surfacique d'un matériau, selon la présente invention,

- la figure 4 représente l'évolution du facteur correcteur de la mesure effectuée avec un appareil selon la présente invention, en fonction du rapport de la largeur de l'objet à mesurer à la largeur de la sonde,

- la figure 5 représente un schéma illustrant le principe du raccordement en "quatre fils",

- la figure 6 représente, de façon schématique, la technique de mesure, dite à "quatre points", de la résistance surfacique d'un échantillon présentant une forme rectangulaire,

- la figure 7 illustre le principe d'une mesure de la résistivité de surface d'un matériau, en appliquant la méthode dite de "VAN DER PAUW".

- la figure 8 représente une fonction intervenant dans le calcul de la résistance selon la méthode de Van Der Pauw.

Description détaillée de l'invention

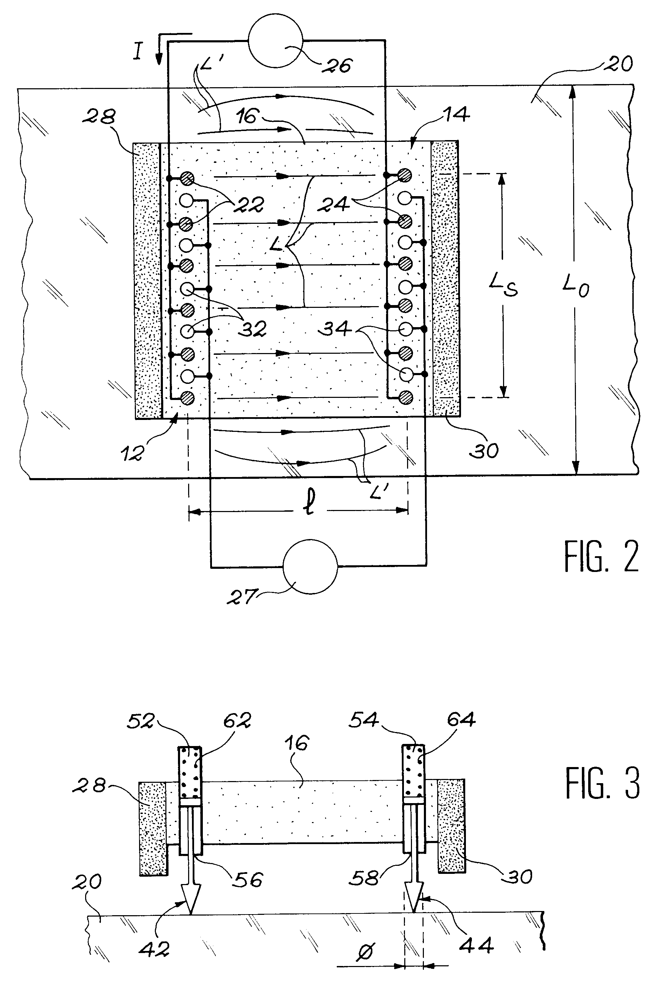

Un mode particulier de réalisation de l'invention est illustré sur les figures 2 et 3.

La sonde comporte deux ensembles d'électrodes 12, 14, qui traversent un support isolant 16.

Un premier ensemble d'électrodes 12 comporte une première série d'électrodes 22 reliées électriquement en parallèle, ainsi qu'une deuxième série d'électrodes 32 également reliées électriquement en parallèle. Ces deux séries d'électrodes sont enchevêtrées, et il en résulte que les électrodes de la première série et les électrodes de la deuxième série sont disposées de manière alternative : une électrode 22 de la première série est suivie d'une électrode 32 de la deuxième série, elle-même suivie d'une électrode 22 de la première série, etc.

Le deuxième ensemble d'électrodes 14 est situé en regard du premier ensemble d'électrodes 12. L'ensemble 14 est constitué de façon similaire à l'ensemble 12. Il comporte une première série d'électrodes 24 reliées en parallèle, et une deuxième série d'électrodes 34 reliées en parallèle. Ces deux séries sont enchevêtrées et il en résulte, comme pour le premier ensemble, que les électrodes 24 et les électrodes 34 sont disposées de manière alternative.

Du fait de la disposition qui vient d'être décrite, chaque ensemble d'électrodes possède un nombre N d'une série d'électrodes, et un nombre N-1 d'électrodes de l'autre série d'électrodes. Le nombre total d'électrodes d'un des deux ensembles est de préférence égal au nombre total d'électrodes de l'autre ensemble. Pratiquement, il s'est avéré qu'un nombre total de 11 électrodes pour chaque ensemble convient bien pour une sonde de mesure de résistance surfacique définissant entre les deux ensembles d'électrodes une surface carrée d'environ 25 mmx25 mm.

Sur la figure 2, chaque ensemble d'électrodes a été représenté aligné. Les deux ensembles sont donc parallèles, situés à une distance l l'un de l'autre, et s'étendant sur une largeur $L_s$ qui est également appelée largeur de la sonde. Pratiquement, il est commode de choisir $l=L_s$. Ainsi, il a été réalisé une sonde avec $l=L_s \approx$ à 25 mm. On peut également réaliser des sondes présentant d'autres dimensions, par exemple 100 mmx100 mm.

A l'intérieur de chaque ensemble d'électrodes, l'une des deux séries est reliée à un dispositif 26 d'alimentation en courant. Sur la figure 2, ces séries d'électrodes sont respectivement repérées par les références 22 et 24, et sont représentées par des points noirs. Ainsi, les électrodes 22 sont alimentées en parallèle, et chacune est alimentée par le même courant. Lorsque ces électrodes sont en contact avec la surface d'un matériau désigné sur la figure 2 par la référence 20, des lignes de courant vont être définies à la surface de ce matériau, et vont rejoindre les électrodes 24 qui sont également connectées à la source 26 d'alimentation de courant.

Simultanément, un dispositif 27 de mesure de tension est relié à chacune des deux autres séries d'électrodes restantes. Ces électrodes sont désignées sur la figure 2 par les références 32 et 34 et sont représentées par des points blancs.

Ainsi, connaissant le courant I injecté par les électrodes 22 et la tension V mesurée aux bornes des électrodes 32 et 34, on en déduit facilement la valeur de la résistance surfacique

$$R = \frac{V}{I}$$

. Néanmoins, il faut tenir compte d'un facteur de correction C dû à d'éventuelles fuites des lignes de courant à la surface du matériau. Ces lignes L et L' (figure 2) de courant partent des électrodes 22, là où le courant est injecté à la surface du matériau, et vont rejoindre les électrodes 24. Cependant, seule une partie L de ces lignes est captée par les sondes de mesure de tension 32 et 34 du fait de la répartition de ces lignes sur toute la surface de l'échantillon. Du fait de la géométrie de la sonde, ce problème ne se pose que si le matériau 20 présente une largeur Lo (mesurée comme indiqué sur la figure 2) supérieure à la valeur de $L_s$. Si le matériau présente une largeur Lo égale à $L_s$, alors ce phénomène de fuite de certaines lignes de courant ne peut se produire. Dans ce cas, la résistance surfacique du matériau est effectivement égale à

$$\frac{V}{I}$$

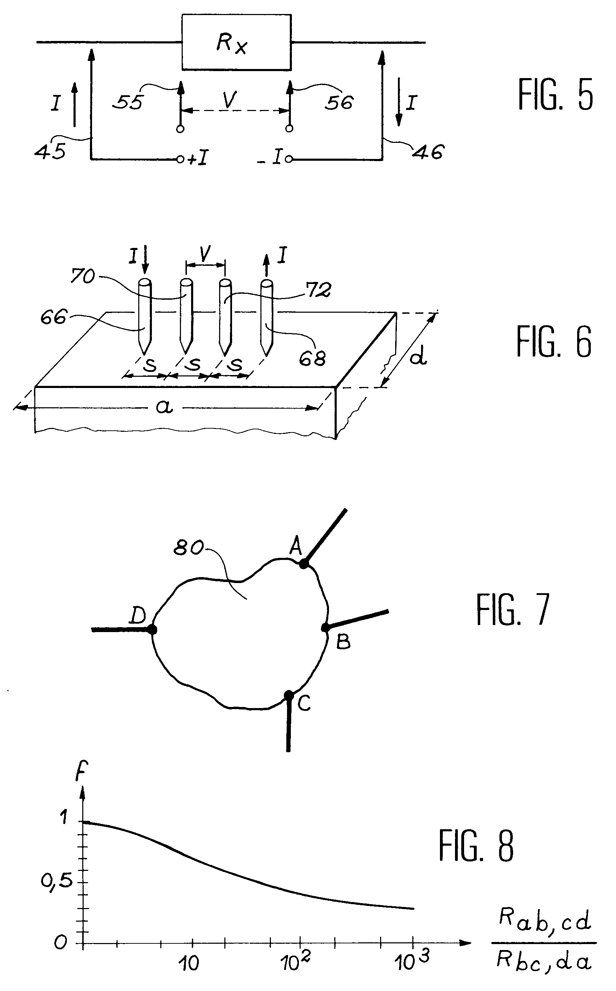

. Si, au contraire, la largeur Lo du matériau est supérieure à $L_s$, alors il faut tenir compte d'un facteur de correction que l'on obtient par étalonnage de l'appareil. Ainsi, pour une sonde de 25,4 mmx25,4 mm, le facteur de correction évolue de la façon représentée sur la figure 4. Sur cette figure, on a représenté en abscisse la valeur du rapport de la largeur de l'objet mesuré $L_o$ sur la largeur de la sonde $L_s$. On voit que le facteur de correction C évolue de manière croissante avec

$$\frac{L_o}{L_s}$$

, pour tendre vers une valeur asymptotique de 2. Des valeurs particulières du facteur correcteur C sont données dans

TABLEAU I

le tableau

| $\frac{L_0}{L_s}$ | 1 | 1,25 | 1,5 | 1,75 | 2 | 2 | 4 | 5 | 6 | 7 |
|---|---|---|---|---|---|---|---|---|---|---|
| c | 1 | 1,27 | 1,49 | 1,62 | 1,71 | 1,89 | 1,93 | 1,97 | 1,97 | 1,97 |

.

La géométrie adoptée pour la sonde de mesure selon l'invention a pour fonction d'englober au mieux les lignes de courant et de minimiser les pertes dues aux fuites de certaines de ces lignes de courant.

La sonde présente donc les avantages suivants.

- D'abord, la mesure de la résistance surfacique est très simple : il suffit de la lire directement sur l'appareil si l'objet mesuré présente une largeur égale à celle de la sonde et il suffit de multiplier la valeur lue par un facteur égal à 2 si la largeur de l'objet est au moins cinq fois supérieure à la largeur de la sonde. Ainsi, si on dispose une sonde ayant une largeur $L_s$=25,4 mm, sur un objet présentant une largeur d'au moins 100 mm, il suffira de multiplier la valeur lue par le facteur 2.

- Ensuite, la résistance de contact entre les électrodes et la surface de l'objet influence peu la mesure. En effet, de par la constitution de la sonde, cette dernière est constituée d'une part d'électrodes d'injection ou de prélèvement du courant, et d'autre part d'électrodes de mesure de tension, ce qui permet de réaliser une mesure suivant le principe du raccordement en "quatre fils". Ce principe est illustré sur la figure 5, sur laquelle sont représentées de façon schématique 4 électrodes, deux électrodes 45, 46 pour l'injection et le prélèvement du courant, après avoir traversé une résistance $R_x$, et deux électrodes 55 et 56 de mesure de la tension aux bornes de la résistance $R_x$. Ce montage permet d'éliminer l'influence de la résistance des fils électriques de liaison, puisqu'on ne mesure pas la chute de tension dans les fils et que les résistances 55 et 56 sont parcourues par un courant négligeable. Il permet également d'éliminer l'influence des chutes de tension au niveau des résistances de contact, puisqu'on ne mesure pas la chute de tension dans les électrodes 45 et 46, et que les électrodes 55, 56 sont parcourues par un courant négligeable. Ce principe de raccordement est généralisé dans le cas de la présente invention. La résistance de la surface du matériau joue le rôle de la résistance $R_x$.

La disposition particulière des électrodes, décrite en liaison avec la figure 2, n'est pas la seule possible. En effet, ainsi qu'indiqué déjà ci-dessus, on peut d'une part faire varier le nombre total d'électrodes dans chaque ensemble d'électrodes 12, 14 et on peut également faire varier les valeur 1 et $L_s$. D'autre part, on n'est pas limité à une répartition strictement rectiligne des électrodes à l'intérieur de chaque ensemble 12, 14. Avec une telle disposition, et dans la mesure où les deux ensembles 12, 14, sont toujours situés en regard l'un de l'autre, on obtient toujours l'effet technique recherché, à savoir le fait d'englober au mieux les lignes de courant et de minimiser les pertes de certaines de ces lignes. Il sera nécessaire de définir un nouveau facteur correcteur c' par étalonnage de l'appareil tel que décrit précédemment. D'autre part, le principe du raccordement en "quatre fils" est toujours conservé, avec les avantages qu'il offre.

Afin d'améliorer le contact entre les électrodes de mesure et la surface de l'objet dont on veut mesurer la résistance, les électrodes peuvent présenter la forme d'aiguilles ou de pointes 42, 44, ainsi qu'illustré sur la figure 3. Cette forme permet, en particulier, de percer une éventuelle couche d'oxydation qui se serait formée à la surface de l'objet. Il est en outre, commode de monter chacune des électrodes sur un ressort 62, 64, ce qui permet de supprimer l'influence des défauts de planéité de la surface de l'objet mesuré. La multiplication des points de contact (10 pointes de mesure de tension et 12 pointes d'injection de courant dans le cas de la figure 2), conjuguée à la forme en pointe des électrodes, permet de pallier à la non-homogénéité des matériaux plastiques métallisés pour lesquels l'épaisseur du dépôt de métal n'est pas constante. Ainsi qu'illustré sur la figure 3, chaque ensemble constitué par une électrode et un ressort peut être monté par exemple à l'intérieur d'un cylindre 52, 54. Le cylindre est percé dans sa partie inférieure par un trou 56,58 permettant à l'électrode de se déplacer suivant un axe vertical, le diamètre du trou étant cependant inférieur au diamètre φ de la base de la pointe de l'électrode, afin de limiter l'amplitude du mouvement de cette dernière. De chaque côté du substrat isolant 16, des butées 28, 30 permettent de limiter l'enfoncement des "électrodes-aiguilles", ce qui revient à appliquer une pression uniforme sur l'ensemble de la sonde.

Afin d'évaluer les performances de la sonde selon la présente invention, des tests comparatifs ont été effectués avec d'autres procédés de mesure sur des échantillons calibrés.

Cinq échantillons ont été réalisés :

- échantillon N°1 : plaque d'aluminium de 75mmx24mm et d'épaisseur 0,5mm (résistivité ρ=2,8 μΩ-cm),

- échantillon N°2 : plaque d'aluminium de 75mmx24mm et d'épaisseur 1,6 mm (résistivité ρ=2,8 μΩ-cm),

- échantillon N°3 : plaque d'aluminium de 390mmx190mm et d'épaisseur 1,6mm (résistivité ρ=2,8 μΩ-cm),

- échantillon N°4 : échantillon circulaire (diamètre 170 mm) d'un matériau plastique revêtu d'un film métallique d'épaisseur 0,002mm (0,75µm de nickel + 1,25 µm de cuivre),

- échantillon N°5 : plaque de 75mmx24mm constituée de la même matière que l'échantillon N°4.

Les échantillons 1 à 3 sont donc métalliques, les échantillons 4 et 5 sont des plastiques métallisés.

Les différents appareils et procédés de mesure de la résistance surfacique sont les suivants :

La première méthode est la méthode des quatre pointes alignées. Cette méthode a été décrite dans l'article de F.M. SMITS, intitulé "Measurement of Sheet Resistivities with the Four-Point Probe" publié dans The Bell System Technical Journal, MAI 1958, p. 711 à 718. Cette méthode de mesure permet d'obtenir des valeurs de résistance surfacique sur des échantillons de forme bien définie. En effet, des facteurs correcteurs sont à apporter à la lecture directe, ces facteurs correcteurs étant fonction de la géométrie de la sonde et de l'échantillon de test. Ainsi qu'illustré sur la figure 6, la sonde présente quatre pointes : deux électrodes 66, 68 pour l'injection et le prélèvement du courant I et deux électrodes 70, 72 pour la mesure de la tension V. Les quatre électrodes sont alignées et les deux électrodes de mesure de tension sont situées entre les électrodes d'injection et de prélèvement du courant. Les électrodes sont séparées d'une distance s=6mm l'une de l'autre.

L'article de Smits cité ci-dessus donne les valeurs de la résistivité des matériaux mesurés, en fonction de leur forme. Ainsi, si un échantillon est rectangulaire, comme illustré sur la figure 6, présentant une longueur a et une largeur d, la résistivité est donnée par la formule :

$$\rho = \frac{V}{I} C\left(\frac{a}{d}, \frac{d}{s}\right).$$

Le facteur de correction C est donc fonction des distances a, d, s. Le résultat est donc dépendant de l'orientation de la sonde par rapport au matériau.

Dans le cas d'un échantillon de forme circulaire, la résistivité est donnée par la formule :

$$\rho = \frac{V}{I} C\left(\frac{d}{s}\right),$$

où d représente le diamètre de l'objet.

Les facteurs correcteurs pour chacun de ces cas et pour différentes valeurs de a, d, s sont donnés dans le documents cité ci-dessus.

La deuxième méthode utilisée est la méthode de Van Der Pauw, Cette méthode a été développée pour mesurer la résistance surfacique sur des échantillons de forme quelconque. Elle va être brièvement décrite en liaison avec la figure 7. Sur cette figure, la référence 80 désigne un échantillon sur la tranche duquel on applique quatre contacts électriques A, B, C et D. On notera d l'épaisseur du matériau.

On fait d'abord passer un courant $I_{ab}$ entre les points A et B et on mesure la tension $V_{cd}$ entre les points C et D. On en déduit

$$R_{abcd} = \frac{V_{cd}}{I_{ab}}.$$

On fait ensuite passer un courant $I_{bc}$ entre les points B et C et l'on mesure la tension $V_{da}$ entre les ponts D et A. On obtient donc la résistance

$$R_{bcda} = \frac{V_{da}}{I_{bc}}.$$

La résistivité est donnée en suite par la formule :

$$\rho = \frac{\pi d}{0,69}\left(\frac{R_{abcd} + R_{bcda}}{2}\right)f\left(\frac{R_{abcd}}{R_{bcda}}\right).$$

La figure 8 représente le graphique donnant les valeurs de f en fonction de

$$\frac{R_{abcd}}{R_{bcda}}$$

Ces deux méthodes nécessitent donc l'emploi de facteurs correcteurs complexes ou l'utilisation d'une formule mathématique. La mesure de la résistivité est donc très indirecte.

La troisième méthode utilisée est la méthode mettant en oeuvre un appareil selon la présente invention. On a utilisé une sonde de dimensions 25,4mmx25,4mm, et utilisant 10 pointes de mesure de tension et 12 pointes d'injection et de prélèvement du courant. La méthode de mesure de résistivité a été décrite ci-dessus, et ne nécessite aucun facteur correcteur si l'échantillon est de la largeur de la sonde. Si l'on considère un échantillon de largeur infinie vis-à-vis de la sonde, ce qui est le cas pour l'échantillon n°4, la résistance surfacique est directement obtenue en multipliant par 2 la valeur mesurée.

Les tableaux II et III donnent l'ensemble des mesures de résistance surfacique des cinq échantillons décrits, suivant les trois méthodes citées. Le tableau II compare les résultats (résistance surfacique et résistivité) pour les matériaux métalliques (aluminium). Le tableau III compare les résultats (résistance surfacique) pour les plastiques métallisés.

## 1. Matériaux métalliques

### TABLEAU II

| | | N°1 ALUMINIUM 75x24mm e=0,5mm | | N°2 ALUMINIUM 75x24mm e=1,6mm | | N°3 ALUMINIUM 360x190mm e=1,6mm | |
|---|---|---|---|---|---|---|---|
| | | Résistance surfacique | Résisti- vité $\rho$ | Résistance surfacique | Résisti- vité $\rho$ | Résistance surfacique | Résisti- vité $\rho$ |
| sonde selon l'inven- tion | | $115\mu\Omega/\square$ | $5,75\mu\Omega\text{-cm}$ | $39\mu\Omega/\square$ | $6,25\mu\Omega\text{-cm}$ | $20\mu\Omega/\square$ x2 $=40\mu r/\square$ | $6,4\mu\Omega\text{-cm}$ |
| 4 pointes alignées | | $119\mu\Omega/\square$ | $5,95\mu\Omega\text{-cm}$ | $42\mu\Omega/\square$ | $6,70\mu\Omega\text{-cm}$ | $41\mu\Omega/\square$ | $6,5\mu\Omega\text{-cm}$ |
| Van Der Pauw | | $117\mu\Omega/\square$ | $5,85\mu\Omega\text{-cm}$ | $39\mu\Omega/\square$ | $6,25\mu\Omega\text{-cm}$ | $41\mu\Omega/\square$ | $6,5\mu\Omega\text{-cm}$ |

On voit qu'après application des facteurs correcteurs pour la méthode des quatre pointes alignées et de la formule mathématique pour la méthode de Van Der Pauw, on trouve des résultats similaires à ceux obtenus par lecture directe avec la sonde selon la présente invention.

Pour l'échantillon n°3, de largeur supérieure à la largeur de la sonde selon l'invention, il faut appliquer un facteur correcteur 2 pour obtenir un résultat identique. Ceci vient du fait que l'on ne mesure pas la totalité des lignes de courant qui se répartissent sur toute la surface de l'échantillon, ainsi qu'on l'a déjà expliqué ci-dessus.

Les expériences menées sur des échantillons de cuivre ou de différentes largeurs confirment qu'un facteur correcteur 2 est appliqué pour tout échantillon de largeur au moins 5 fois supérieure à la largeur de la sonde selon la présente invention.

## 2. Surfaces métallisées

TABLEAU III

| | N°4 SURFACE METALLISEE Ø170MM e=0,002mm | N°5 SURFACE METALLISEE 75x24mm e=0,002mm |
|---|---|---|
| sonde de l'invention | 12mΩ/□x2 | 26mΩ/□ |
| 4 pointes alignées | 5 à 6 mΩ/□x4,5324 | 26mΩ/□ |
| Van Der Pauw | 12 à 14 MΩ/□ | 20 à 25mΩ/□ |

On voit que pour les supports métallisés, la méthode de Van Der Pauw ne convient pas. Ceci vient du fait que le dépôt de métal sur la surface du support n'est pas homogène, ce qui rend le résultat dépendant de l'emplacement des sondes de mesure. La méthode des quatre pointes alignées donne un résultat correct si l'on considère le support comme infiniment grand face aux dimensions de la sonde et que l'on applique le facteur correcteur 4,5321 donné dans l'article de SMITS indiqué ci-dessus en référence.

En ce qui concerne l'échantillon n°5, après application des facteurs correcteurs pour la méthode des quatre pointes alignées et de la formule mathématique pour la méthode de Van Der Pauw, on trouve des résultats moins précis que ceux obtenus par lecture directe avec la sonde selon la présente invention.

**Revendications**

1.  Sonde de mesure de résistance surfacique d'un objet (20), caractérisée en ce qu'elle comporte deux ensembles (12, 14) d'électrodes en regard l'un de l'autre, chaque ensemble comportant :

    -   une première série d'électrodes (22, 24) reliées en parallèle,

    -   une deuxième série d'électrodes (32, 34) reliées en parallèle,

    les deux séries d'électrodes étant disposées de manière alternative.

2.  Sonde de mesure de résistance surfacique selon la revendication 1, comportant en outre :

    -   des moyens (26) d'alimentation en courant I reliés à l'une des séries d'électrodes (22, 24) reliées en parallèle de chaque ensemble d'électrodes, et

    -   des moyens (27) de mesure d'une tension V entre les deux autres séries d'électrodes (32,34).

3.  Sonde de mesure selon l'une des revendications 1 ou 2, caractérisée en ce que chaque ensemble d'électrodes est disposé rectilignement, les deux ensembles d'électrodes définissant ainsi deux alignements parallèles d'électrodes.

4.  Sonde de mesure selon l'une des revendications 1 à 3, caractérisée en ce que la longueur ($L_s$) d'un ensemble d'électrodes est sensiblement égale à celle de l'autre ensemble d'électrodes.

5.  Sonde de mesure selon la revendication 4, caractérisée en ce que la longueur ($L_s$) de chaque ensemble d'électrodes est égale à la distance (1) séparant les deux ensembles d'électrodes.

6.  Sonde de mesure selon l'une des revendications précédentes, caractérisée en ce que chaque électrode est en forme de pointe (42, 44) à l'extrémité destinée à être en contact avec l'objet (20) à mesurer.

7.  Sonde de mesure selon la revendication 6, caractérisée en ce que chaque pointe est montée sur un ressort (62, 64).

8.  Procédé de mesure de la résistance surfacique d'un objet comprenant les étapes suivantes :

- application sur la surface de l'objet (20) d'une sonde selon la revendication 2,

- injection d'un courant électrique I,

- mesure de la tension V,

- calcul de la résistance surfacique

$$R = \frac{V}{I},$$

- correction du résultat par un facteur correcteur C préétabli dépendant du rapport de la largeur de l'objet à la largeur de la sonde

$$\frac{L_o}{L_s}$$

.

FIG. 1

FIG. 4

FIG. 2

FIG. 3

FIG. 5

FIG. 6

FIG. 7

FIG. 8

**Office européen des brevets**

# RAPPORT DE RECHERCHE EUROPEENNE

Numero de la demande

EP 95 40 1770

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| Y | DE-C-42 42 585 (SIEMENS)<br>* abrégé; figures *<br>* colonne 1, ligne 13 - ligne 20 *<br>* colonne 1, ligne 35 - ligne 45 *<br>--- | 1-8 | G01R27/02 |
| Y | EP-A-0 299 875 (MITSUBISHI PETROCHEMICAL)<br>* page 2, ligne 34 - ligne 37 *<br>* abrégé; figures 17-23 *<br>--- | 1-8 | |
| A | GB-A-2 273 990 (AT&T)<br>* abrégé; figure 7 *<br>* page 5, ligne 30 - ligne 33 *<br>--- | 5 | |
| A | US-A-3 735 253 (E.J.SEGER)<br>* abrégé; figures 1,3,4 *<br>* colonne 2, ligne 38 - ligne 42 *<br>* colonne 3, ligne 64 - ligne 67 *<br>* colonne 4, ligne 6 - ligne 21 *<br>* colonne 5, ligne 43 - colonne 6, ligne 19 *<br>----- | 1,8 | |
| | | | **DOMAINES TECHNIQUES RECHERCHES (Int.Cl.6)**<br><br>G01R<br>G01N |

Le présent rapport a été établi pour toutes les revendications

| Lieu de la recherche | Date d'achèvement de la recherche | Examinateur |
|---|---|---|
| BERLIN | 6 Octobre 1995 | Fritz, S |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)